# DEMANDE DE BREVET EUROPEEN

(11) **EP 1 455 559 A1**
(43) Date de publication de la demande: **08.09.2004**
(21) Numéro de dépôt: 04290512.5
(22) Date de dépôt: 25.02.2004
(51) Int. Cl.: H05K 7/14, H05K 5/00, H02M 7/00, B60L 3/00

(54) **Module électronique de puissance avec bornes de connexion et transformateurs de courant**

(30) Priorité: 03.03.2003 FR 0302528
(71) Demandeur: Renault s.a.s., 92100 Boulogne Billancourt (FR)
(72) Inventeur: Lecoq, Frédéric, 78180 Montigny le Bretonneux (FR)
(74) Mandataire: Davies, Owen Robert Treharne

(57) **Abrégé**

Un module électronique de puissance comporte une embase (15), au moins une borne de connexion (12a), un transformateur de courant (17) de forme annulaire traversé par la borne de connexion (12a) pour mesurer le courant circulant dans la borne de connexion (12a), la borne de connexion (12a) comportant une face d'appui (120a) destinée à être en contact électrique avec un élément électrique externe. La borne de connexion (12a) comporte une portion souple (121) conductrice traversant le transformateur de courant (17) et une plaque terminale (120) reliée à la portion souple comportant la face d'appui (120a).

## Description

L'invention concerne un module électronique de puissance, et en particulier une disposition de borne de connexion dans un tel module.

Un module électronique de puissance permet de fournir à un récepteur un courant électrique modulé en fonction des besoins. Par exemple, un tel module peut intervenir dans l'alimentation d'un moteur électrique pour lequel la puissance, le couple ou la vitesse de rotation doit être modulé, en fournissant un courant alternatif de tension et de fréquence variable. Cette modulation est réalisée par des composants électroniques intégrés au module. Souvent, des transformateurs de courant sont prévus pour mesurer l'intensité du courant délivré au récepteur. Ces mesures sont utiles pour la régulation du courant délivré.

Le document WO 00/27020 montre par exemple un convertisseur comportant un cadre sur lequel sont fixées des bornes de connexion électrique. Ces bornes de connexion ont la forme de broches s'étendant perpendiculairement au cadre et dans lesquelles un courant est destiné à circuler. Elles sont destinées à recevoir un câblage pour connecter des éléments externes au convertisseur. Pour cela, elles comportent des trous axiaux taraudés pour recevoir des vis de fixation du câblage en contact avec une face d'appui perpendiculaire à l'axe des broches. Des transformateurs de courant ayant une forme annulaire, par exemple toroïdale, entourent certaines des bornes pour mesurer le courant qui peut les traverser.

L'intégration d'un module de puissance dans un véhicule exige que le module ait un encombrement minimal. Cependant, l'encombrement du convertisseur du document WO 00/27020 n'est pas optimisé. En effet, la position des transformateurs de courant augmente la largeur du convertisseur de la dimension maximale d'encombrement du transformateur. Cela dit, une autre orientation des transformateurs conduit à concevoir une borne de connexion de forme plus complexe et un montage plus délicat, si on souhaite conserver la même disposition pour la connexion vers des éléments externes.

C'est donc un objectif de l'invention de fournir un module électronique de puissance compact comportant des bornes de connexion et des transformateurs de courant, dont le montage et la réalisation soient simples.

Avec cet objectif en vue, l'invention a pour objet un module électronique de puissance comportant une embase, au moins une borne de connexion, un transformateur de courant de forme annulaire traversé par la borne de connexion pour mesurer l'intensité du courant circulant dans la borne de connexion, la borne de connexion comportant une face d'appui destinée à être en contact électrique avec un élément électrique externe. Selon l'invention, la borne de connexion comporte une portion conductrice souple traversant le transformateur de courant et une plaque terminale, la plaque terminale reliée à la portion souple comportant la face d'appui.

Ainsi, grâce à l'invention, la borne de connexion peut être facilement montée de telle sorte qu'elle traverse le transformateur de courant, quelle que soit la position du transformateur par rapport à la position définitive de la plaque terminale. En effet, la souplesse de la portion conductrice souple permet d'introduire la borne dans l'anneau du transformateur et de lui donner ensuite une forme quelconque pour mettre en place définitivement la plaque terminale.

De préférence, un axe du transformateur de courant est sensiblement parallèle à la face d'appui. Ainsi, l'encombrement du transformateur dans une direction parallèle à la surface d'appui est la dimension la plus petite du transformateur, c'est-à-dire l'épaisseur de la forme annulaire. En conséquence, dans cette direction, l'encombrement du module dû au transformateur est minimal.

Selon un mode de réalisation particulier, la portion souple comporte une tresse de métal conducteur.

De manière particulière, la tresse a une section aplatie. Ainsi, à section conductrice constante, elle a une direction préférentielle de flexion.

La portion souple est reliée à une première extrémité à la plaque terminale, sa deuxième extrémité se prolongeant par une patte comportant une face de soudage pour recevoir des fils en provenance d'un composant électronique.

L'embase est obtenue par moulage d'une résine synthétique et la patte est surmoulée dans l'embase, la face de soudage restant apparente. Le surmoulage réalise la fixation mécanique de la borne sur l'embase, ainsi que l'isolation électrique.

La face de soudage est sensiblement dans le même plan que la face d'appui. Ainsi, des bornes de connexion qui ne nécessitent pas de transformateur de courant sont proches des autres bornes de connexion tout en étant très directes et courtes.

L'invention sera mieux comprise et d'autres particularités et avantages apparaîtront à la lecture de la description qui va suivre, la description faisant référence aux dessins annexés parmi lesquels :
- la figure 1 est une vue en perspective d'un module conforme à l'invention ;
- la figure 2 est une vue en perspective et en éclaté du module de la figure 1 ;
- la figure 3 est une vue de dessus, sans capot, d'une embase du module de la figure 1 ;
- la figure 4 est une vue en coupe partielle selon la ligne IV-IV de la figure 3 ;
- la figure 5 est une vue de face de l'embase de la figure 3 ;
- les figures 6 et 7 sont des vues en perspective de bornes de connexion du module de la figure 1.

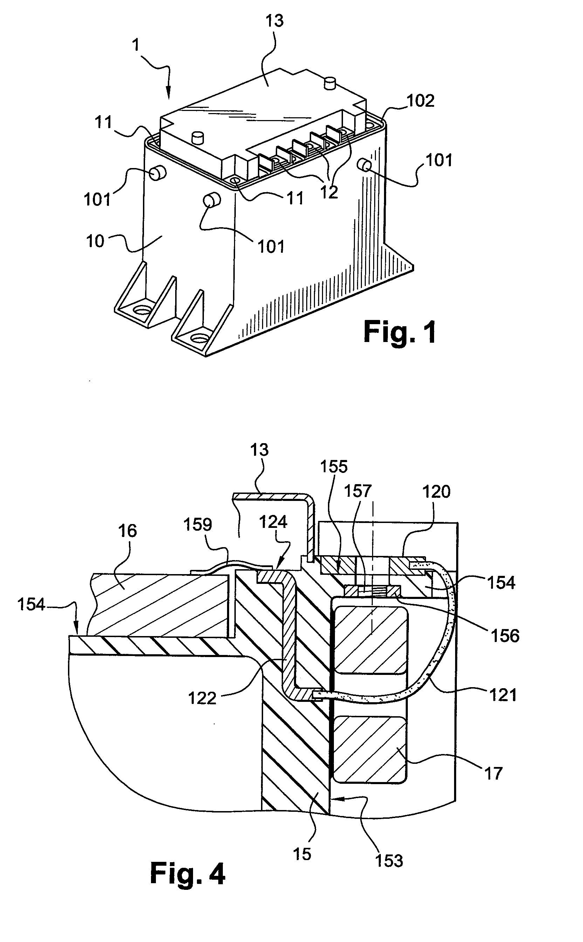

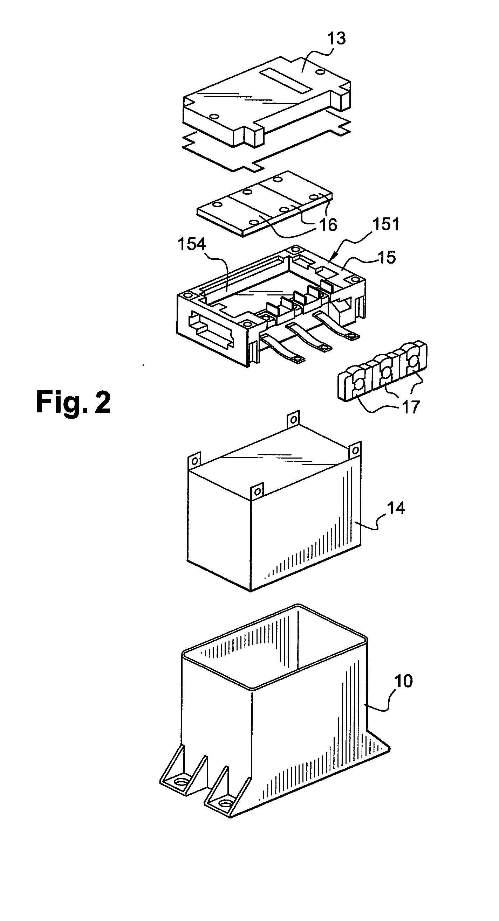

Un module 1 électronique de puissance conforme à l'invention est montré sur les figures 1 et 2. Ce module 1 comporte un boîtier 10 de forme parallélépipédique rectangle dont la face supérieure est ouverte. Il comporte des bornes de connexion d'entrée 11 situées aux quatre sommets de la face supérieure. Le module 1 comporte également six bornes de connexion de sortie 12a, 12b le long d'un bord de la face supérieure. Un capot 13 est fixé au niveau de la face supérieure et fait saillie par rapport à la face supérieure, sans couvrir les bornes de connexion.

Les éléments internes du module apparaissent sur la figure 2 en éclaté. Le module 1 comporte un condensateur 14 de forme parallélépipédique rectangle et une embase 15 surmontée par le capot 13. Le condensateur 14 est fixé à l'embase 15. L'ensemble formé par l'embase 15 et le condensateur 14 est contenu dans le boîtier 10 et fixé par exemple par les vis 101 traversant le boîtier 10.

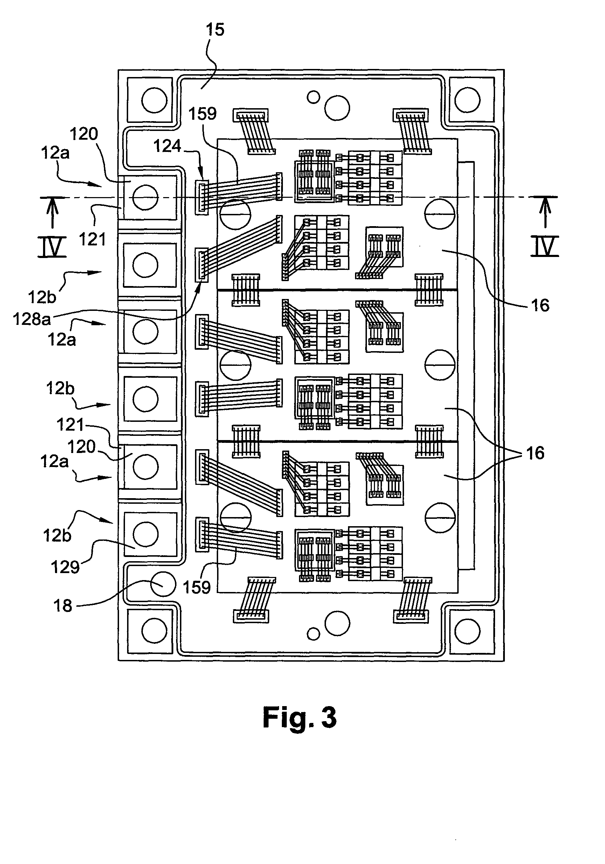

L'embase 15, représentée sur les figures 3 à 5, est une pièce obtenue par moulage d'une résine synthétique. Elle comporte des composants électroniques de puissance pour commuter un courant électrique. Les composants électroniques sont répartis sur trois éléments 16, disposés côte à côte et fixés dans une cavité 154 d'une première face 151 de l'embase 15. L'embase 15 comporte également les bornes de connexion d'entrée 11 et de sortie 12a, 12b. Les bornes de connexion 11, 12a, 12b sont des pièces métalliques, par exemple en cuivre, insérées dans l'embase 15 par surmoulage.

Trois transformateurs de courant 17 sont prévus pour mesurer l'intensité du courant délivré par le module à un récepteur. Dans cette configuration, le récepteur à alimenter par le module est prévu du type triphasé, avec trois dipôles. Chaque dipôle est prévu pour être relié à deux bornes de connexion de sortie du module pour former un circuit électrique avec le module. Un transformateur de courant est destiné à mesurer l'intensité du courant dans ledit circuit.

Chaque transformateur de courant 17 a une forme annulaire et mesure le courant traversant un conducteur passant par l'axe de l'anneau, d'une manière connue en soi. Ici, le transformateur 17 est fixé contre une face latérale 153 de l'embase, par exemple par collage, et est traversé par un conducteur que comporte une borne de sortie dite à mesure 12a. L'autre borne 12b pour connecter le dipôle est dite directe. Les trois transformateurs 17 sont disposés côte à côte, le long du même côté que les bornes de sorties.

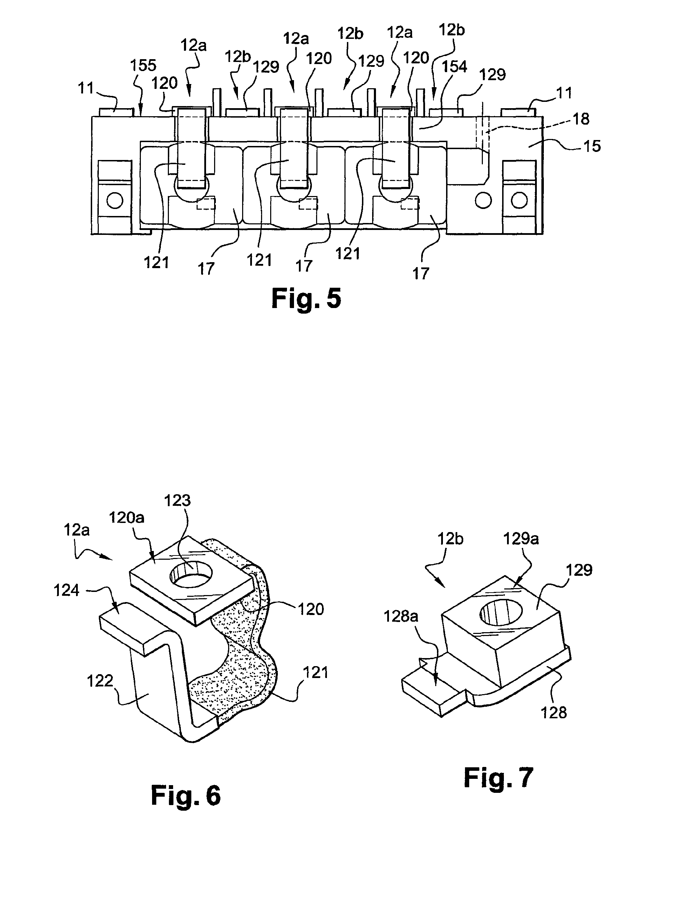

En se rapportant en particulier aux figures 4 et 6, une borne de sortie à mesure 12a comporte une plaque terminale 120 de forme carrée, une portion souple 121 et une patte 122. La patte 122 et la plaque terminale 120 sont réalisées en cuivre, tandis que la portion souple est réalisée par une tresse de cuivre. La tresse a une section aplatie, sensiblement rectangulaire, pour que sa flexion soit facilitée. La plaque terminale 120 comporte un perçage 123 pour le passage d'une vis. La patte a une forme d'escalier. La portion souple 121 est reliée à une première extrémité à la plaque terminale 120, et à la deuxième extrémité à la patte 122, par exemple par soudure ou par sertissage. La patte 122 et la plaque terminale 120 ont également une section rectangulaire, comparable et dans le prolongement de la section de la portion souple 121.

La borne de sortie à mesure 12a est surmoulée dans l'embase 15 de telle sorte que la patte 122 soit entièrement insérée dans l'embase, hormis une face de soudage 124 restant à nu et affleurant la première face 151 de l'embase 15. Ainsi, la portion souple 121 et la plaque terminale 120 sont libres. La portion souple 121 traverse le transformateur de courant 17 par le centre de l'anneau.

L'embase 15 comporte également une tablette 154 qui s'étend au-dessus des transformateurs de courant 17. La tablette 154 comporte une face de support 155 sensiblement parallèle à la première face 151 de l'embase. Les plaques terminales 120 sont rabattues sur la face de support 155 de la tablette 154.

La tablette 154 incorpore un insert métallique 156 comportant un trou taraudé 157. Cet insert 156 est destiné à recevoir une vis pour connecter un câble électrique, non représenté. La connexion du câble permet également de fixer la plaque terminale 120.

Chaque borne de connexion de sortie à mesure 12a est associée à une borne de connexion de sortie directe 12b, pour la connexion d'une deuxième branche du dipôle. En référence à la figure 7, la borne de connexion de sortie directe 12b comporte une bande 128 sur laquelle est fixé un écrou carré 129, par exemple par soudure. Elle comporte également une face de soudage 128a. La borne de connexion de sortie directe 12b est surmoulée également dans l'embase de telle sorte qu'elle soit entièrement insérée dans l'embase, hormis la face de soudage 128a restant à nu et affleurant la première face 151 de l'embase 15. La face supérieure de l'écrou 129 reste également à nu, l'écrou 129 étant inséré dans la tablette 154, la face supérieure de l'écrou 129a étant alignée avec les plaques terminales 120. L'écrou 129 est destiné à recevoir une vis pour connecter un câble électrique, non représenté.

Comme on le voit plus particulièrement sur la figure 3, les éléments 16 portant les composants électroniques sont reliés électriquement aux bornes de connexion de sortie 12a, 12b par des fils 159 par exemple en aluminium, soudés d'une part sur les éléments 16 et d'autre part sur les faces de soudage 124, 128a. Le nombre de fils 159 est déterminé en fonction de l'intensité du courant à faire passer entre les bornes de connexion et les composants. Les bornes de connexion d'entrée 11 sont reliées aux éléments 16 de la même manière.

Les transformateurs de courant 17 comportent des fils de mesure, non représentés, qui sont reliés à une carte de contrôle, non représentée et logée dans le capot 13. Un orifice 18 est prévu dans l'embase 15 pour le passage des fils de mesure vers la carte de contrôle.

Le module 1 est destiné à être monté dans un véhicule automobile pour commuter un courant continu en provenance d'accumulateurs vers un moteur électrique, ou éventuellement dans un sens inverse en cas de freinage en récupérant l'énergie cinétique du véhicule pour recharger les accumulateurs. Le moteur est connecté aux bornes de sortie 12a, 12b, tandis que les accumulateurs sont connectés aux bornes d'entrée 11, par l'intermédiaire de câbles électriques, non représentés.

Pour le montage du module 1, on rapproche les transformateurs 17 de la face latérale 153 en faisant passer les plaques terminales 120 puis les portions souples 121 dans l'axe de l'anneau. On fixe les transformateurs contre la face latérale 153 avec de la colle. Puis, les plaques terminales 120 sont rabattues sur la tablette 154. On constate que le montage des transformateurs 17 est très simple et que leur encombrement est minimal dans une direction perpendiculaire à la face latérale 153.

## Revendications

1. Module électronique de puissance comportant une embase (15), au moins une borne de connexion (12a), un transformateur de courant (17) de forme annulaire traversé par la borne de connexion (12a) pour mesurer le courant circulant dans la borne de connexion (12a), la borne de connexion (12a) comportant une face d'appui (120a) destinée à être en contact électrique avec un élément électrique externe, **caractérisé en ce que** la borne de connexion (12a) comporte une portion souple (121) conductrice traversant le transformateur de courant (17) et une plaque terminale (120) reliée à la portion souple (121), la plaque terminale (120) comportant la face d'appui (120a).

2. Module selon la revendication 1, selon lequel un axe du transformateur de courant (17) est sensiblement parallèle à la face d'appui (120a).

3. Module selon la revendication 1, selon lequel la portion souple (121) comporte une tresse de métal conducteur.

4. Module selon la revendication Module selon la revendication 1, selon lequel la portion souple (121) comporte une tresse de métal conducteur., selon lequel la tresse (121) a une section aplatie.

5. Module selon la revendication 1, selon lequel la portion souple (121) est reliée à une première extrémité à la plaque terminale (120), sa deuxième extrémité se prolongeant par une patte (122) comportant une face de soudage (124) pour recevoir des fils (159) en provenance d'un composant électronique.

6. Module selon la revendication Module selon la revendication 1, selon lequel la portion souple (121) est reliée à une première extrémité à la plaque terminale (120), sa deuxième extrémité se prolongeant par une patte (122) comportant une face de soudage (124) pour recevoir des fils (159) en provenance d'un composant électronique., selon lequel l'embase (15) est obtenue par moulage d'une résine synthétique et la patte (122) est surmoulée dans l'embase (15), la face de soudage (124) restant apparente.

7. Module selon la revendication Module selon la revendication 1, selon lequel la portion souple (121) est reliée à une première extrémité à la plaque terminale (120), sa deuxième extrémité se prolongeant par une patte (122) comportant une face de soudage (124) pour recevoir des fils (159) en provenance d'un composant électronique., selon lequel la face de soudage (124) est sensiblement dans le même plan que la face d'appui (120a).
